# EUROPÄISCHE PATENTSCHRIFT

(11) **EP 1 136 596 B1**
(45) Veröffentlichungstag und Bekanntmachung des Hinweises auf die Patenterteilung: **07.08.2002**
(21) Anmeldenummer: 01103569.8
(22) Anmeldetag: 20.02.2001
(51) Int. Cl.: C30B 15/00, C30B 29/06

(54) **Halbleiterscheibe aus Silicium und Verfahren zur Herstellung der Halbleiterscheibe**
Silicon wafer and its method of fabrication
Plaquette de silicium et sa méthode de fabrication

(30) Priorität: 24.03.2000 DE 10014650
(43) Veröffentlichungstag der Anmeldung: 26.09.2001
(73) Patentinhaber: Wacker Siltronic Gesellschaft für Halbleitermaterialien Aktiengesellschaft, 84489 Burghausen (DE)
(72) Erfinder: Ammon von, Wilfried, Dr., 5122 Hochburg/Ach (AT); Schmolke, Rüdiger, Dr., 84489 Burghausen (DE); Daub, Erich, Dr., 84547 Emmerting (DE); Frey, Christoph, Dr., 84489 Burghausen (DE)
(74) Vertreter: Rimböck, Karl-Heinz, Dr.

(56) Entgegenhaltungen:
- EP-A- 0 170 788
- EP-A- 0 829 559
- DE-A- 2 147 514
- US-A- 5 505 157
- PATENT ABSTRACTS OF JAPAN vol. 1999, no. 12, 29. Oktober 1999 (1999-10-29) & JP 11 189495 A (SUMITOMO METAL IND LTD), 13. Juli 1999 (1999-07-13)
- PATENT ABSTRACTS OF JAPAN vol. 1995, no. 08, 29. September 1995 (1995-09-29) & JP 07 126094 A (HITACHI LTD;OTHERS: 01), 16. Mai 1995 (1995-05-16)
- IINO E ET AL: "CAVITIES OWING TO HYDROGEN IN SI SINGLE CRYSTALS GROWN BY CONTINUOUSLY CHARGING CZ METHOD" MATERIALS SCIENCE AND ENGINEERING B,CH,ELSEVIER SEQUOIA, LAUSANNE, Bd. B36, Nr. 1/03, 1996, Seiten 146-149, XP000627149 ISSN: 0921-5107
- PATENT ABSTRACTS OF JAPAN vol. 10, no. 390 (C-394) [2447], 26. Dezember 1986 (1986-12-26) & JP 61 178495 A (FUJITSU LTD), 11. August 1986 (1986-08-11)
- HARA A ET AL: "INFLUENCE OF GROWN-IN HYDROGEN ON THERMAL DONOR FORMATION AND OXYGEN PRECIPITATION IN CZOCHRALSKI SILICON CRYSTALS" JAPANESE JOURNAL OF APPLIED PHYSICS,JP,PUBLICATION OFFICE JAPANESE JOURNAL OF APPLIED PHYSICS. TOKYO, Bd. 33, Nr. 10, PART 01, 1. Oktober 1994 (1994-10-01), Seiten 5577-5584, XP000596956 ISSN: 0021-4922
- HARA A ET AL: "HYDROGEN IN AS-GROWN CZOCHRALSKI SILICON CRYSTALS" EXTENDED ABSTRACTS OF THE INTERNATIONAL CONFERENCE ON SOLID STATE DEVICES AND MATERIALS,JAPAN SOCIETY OF APPLIED PHYSICS. TOKYO,JA, 29. August 1993 (1993-08-29), Seiten 1014-1016, XP000409522

## Beschreibung

Gegenstand der Erfindung ist ein Verfahren zur Herstellung einer Halbleiterscheibe aus Silicium, die von einem Einkristall stammt, der nach der Czochralski-Methode (Cz-Methode) aus einer Schmelze gezogen wurde.

Ein solchermaßen gezogener Einkristall und eine davon abgetrennte Halbleiterscheibe weisen in der Regel Leerstellendefekte, sogenannte Voids, auf. Diese Agglomerate von Leerstellen stören bei der Herstellung von elektronischen Bauelementen. Es ist bekannt, daß durch Tempern der Halbleiterscheibe in einer reinen Wasserstoffatmosphäre bei einer Temperatur von mehr als 1100 °C die Defekte zumindest in einem oberflächennahen Bereich der Halbleiterscheibe aufgelöst werden können.

Gemäß Untersuchungen von E.lino et al., die in Materials Science and Engineering B 36 (1996) 146 veröffentlicht worden sind, induziert die Gegenwart von Wasserstoff beim Ziehen des Einkristalls nach der Cz-Methode eine andere Defektart im Einkristall, sogenannte cavities, die den Einkristall als Grundmaterial zur Herstellung elektronischer Bauelemente sogar unbrauchbar macht.

In den PATENT ABSTRACTS OF JAPAN vol.10. no.390 (C-394) [2447], 26. Dezember 1986 (1986-12-26) und der darin genannten JP-61-178495 A ist ein Verfahren beschrieben, bei dem ein Einkristall aus Silicium in Gegenwart von 1,5 bis 3% Wasserstoff gezogen wird.

Aufgabe der vorliegenden Erfindung ist es, Probleme mit Leerstellendefekten weitgehend zu beseitigen.

Gegenstand der Erfindung ist ein Verfahren zur Herstellung einer Halbleiterscheibe aus Silicium durch Abtrennen der Halbleiterscheibe von einem Einkristall, wobei der Einkristall nach der Czochralski-Methode in Gegenwart von Wasserstoff aus einer Schmelze gezogen wird, das dadurch gekennzeichnet ist, daß der Einkristall bei einem Wasserstoff-Partialdruck von weniger als 3 mbar gezogen und mit Stickstoff dotiert wird und eine Stickstoff Konzentration von 5*10¹² bis 5*10¹⁵ atcm⁻³ aufweist.

Bei Anwendung des Verfahrens entstehen zwar weiterhin Leerstellendefekte im Einkristall und den davon abgetrennten Halbleiterscheiben. Die Bildung von cavities, wie sie von E.lino et al. beschrieben wurden, wird jedoch nicht beobachtet. Besonders bevorzugt ist ein Wasserstoff-Partialdruck von weniger als 1 mbar. Der Partialdruck sollte während des Ziehens des Einkristalls möglichst konstant gehalten werden, so daß Wasserstoff in der gewünschten Konzentration gleichmäßig im wachsenden Einkristall eingebaut wird. Dabei ist zu berücksichtigen, daß ein Teil des Wasserstoffs aus der Schmelze getrieben wird.

Wird der Einkristall in der vorgeschlagenen Konzentration mit Wasserstoff dotiert, dann gerät dieser beim Abkühlen des wachsenden Kristalls zusammen mit den Leerstellen in Übersättigung. Während die Leerstellen zu voids (Mikrohohlräume) aggregieren, lagert sich der Wasserstoff in die entstehenden oder entstandenen voids ein. Wichtig ist, daß die Wasserstoffkonzentration so niedrig gewählt wird, daß die entstehende Übersättigung nur zu einer Einlagerung in die voids ausreicht, aber nicht für die Bildung eigener Wasserstoffpräzipitate. Die optimale Wasserstoffkonzentration ist abhängig von der Abkühlgeschwindigkeit des wachsenden Kristalls. Beim weiteren Abkühlen verhindert der Wasserstoff in den voids, daß der ebenfalls in Übersättigung geratene Sauerstoff die Innenflächen der voids oxidieren kann. Somit entsteht keine Oxidschicht, die das Auflösen der voids durch thermische Behandlung der aus dem Einkristall gewonnenen Halbleiterscheibe sonst deutlich verzögert. Eine thermische Behandlung der Halbleiterscheibe bei einer Temperatur von ca. 1200 °C für einen Zeitraum von 60 min in einer Atmosphäre, die höchstens nur noch 3 % Wasserstoff enthalten muß,ist daher bereits ausreichend, um die Leestellendefekte im Bereich des Halbleitermaterials, in dem elektronische Bauelemente vorgesehen sind, zu beseitigen. In den Fällen, in denen die Halbleiterscheibe während der Herstellung der Bauelemente den geschilderten Bedingungen ohnehin ausgesetzt werden muß, ist es zweckmäßig, auf die thermische Behandlung der Halbleiterscheibe zu verzichten. In den anderen Fällen ist erfindungsgemäß ein Temperschritt durchzuführen, wobei eine Wärmebehandlung der Halbleiterscheibe in einer Wasserstoff und Argon enthaltenden Atmosphäre bevorzugt ist, besonders bevorzugt eine Wärmebehandlung in einer Atmosphäre, die Argon und 3% Wassertoff enthält. Die Temperatur und die Dauer der Wärmebehandlung sollte vom Ofen abhängig gemacht werden, der benutzt wird. Bei einem mit Lampen beheizten, sogenannten rapid thermal anneal Ofen (Einscheibenprozeß) wird eine Wärmebehandlung bei einer Temperatur von 1150 bis 1250°C, bevorzugt 1200 °C, und einer Behandlungsdauer von bis zu 60s, bevorzugt 30s, gewählt. Bei Verwendung eines Ofens mit Widerstandsheizung (Batchprozeß) ist eine Temperatur von 1050 bis 1200°C, bevorzugt 1100 °C und eine Behandlungsdauer von bis zu 60min, bevorzugt 30 min zu wählen. In jedem Fall ermöglicht die Erfindung, daß auf ein Tempern der Halbleiterscheibe in einer reinen Wasserstoffatmosphäre und den damit verbundenen Sicherheitsproblemen verzichtet und die Dauer des Tempems deutlich verkürzt werden kann. Die Wärmebehandlung kann auch unter oxidativen Bedingungen stattfinden bzw. mit einem oxidativen Temperschritt kombiniert werden.

Es ist weiterhin vorteilhaft, das Volumen der Leerstellendefekte möglichst klein zu halten, so daß sie später leichter aufgelöst werden können. Dies gelingt dadurch, daß der Einkristall beim Ziehen zusätzlich mit Stickstoff dotiert und vorzugsweise zwangsweise abgekühlt wird. Eine geeignete Stickstoff-Konzentration liegt zwischen 5*10¹² und 5*10¹⁵ atcm⁻³. Vorzugsweise wird die Stickstoffkonzentration zwischen 1x10¹⁴ und 1x10¹⁵ gewählt. Als Dotierstoff eignen sich NH₃ oder Siliciumnitrid, wobei letzteres vorzugsweise in Pulverform oder als nitridbeschichtete Siliciumscheibe der Schmelze zugeführt wird. Zur Kühlung des Einkristalls wird ein vorzugsweise mit Wasser kühlbarer Wärmeschild um den Einkristall angeordnet. Eine solche Vorrichtung ist beispielsweise in der EP 0 725 169 B1 offenbart. Die Kühlung erfolgt dabei vorzugsweise so, daß der Zeitraum, in dem der gerade gewachsene Einkristall von einer Temperatur von 1050 °C auf eine Temperatur von 900 °C abkühlt, weniger als 120 min beträgt.

Die erfindungsgemäß hergestellte Halbleiterscheibe eignet sich in besonderem Maße auch als Substratscheibe, auf die eine epitaktische Schicht abgeschieden wird.

## Patentansprüche

1. Verfahren zur Herstellung einer Halbleiterscheibe aus Silicium durch Abtrennen der Halbleiterscheibe von einem Einkristall, wobei der Einkristall nach der Czochralski-Methode in Gegenwart von Wasserstoff aus einer Schmelze gezogen wird, **dadurch gekennzeichnet, daß** der Einkristall bei einem Wasserstoff-Partialdruck von weniger als 3 mbar gezogen und mit Stickstoff dotiert wird und eine Stickstoff-Konzentration von 5*10¹² bis 5*10¹⁵ atcm⁻³ aufweist.

2. Verfahren nach Anspruch 1, **dadurch gekennzeichnet, daß** ein gekühlter Wärmeschild um den Einkristall angeordnet wird, und der Einkristall mit Hilfe des Wärmeschilds gekühlt wird, wobei ein Zeitraum, in dem der Einkristall von einer Temperatur von 1050 °C auf eine Temperatur von 900 °C abkühlt, weniger als 120 min beträgt.

3. Verfahren nach Anspruch 1 oder Anspruch 2, **dadurch gekennzeichnet, daß** die Halbleiterscheibe einer Wärmebehandlung in einer Atmosphäre unterzogen wird, die Argon und bis zu 3% Wasserstoff enthält.

4. Verfahren nach einem der Ansprüche 1 bis 3, **dadurch gekennzeichnet, daß** die Halbleiterscheibe einer Oxidationsbehandlung unterzogen wird.

## Claims

1. Method for producing a semiconductor wafer from silicon by separating the semiconductor wafer from a single crystal, the single crystal being pulled from a melt, in the presence of hydrogen, using the Czochralski method, **characterized in that** the single crystal is pulled at a hydrogen partial pressure of less than 3 mbar and is doped with nitrogen and has a nitrogen concentration of 5*10¹² to 5*10¹⁵ atcm⁻³.

2. Method according to Claim 1, **characterized in that** a cooled heat shield is arranged around the single crystal, and the single crystal is cooled with the aid of the heat shield, a period within which the single crystal cools from a temperature of 1050/C to a temperature of 900/C amounting to less than 120 min.

3. Method according to Claim 1 or Claim 2, **characterized in that** the semiconductor wafer is subjected to a heat treatment in an atmosphere which contains argon and up to 3% hydrogen.

4. Method according to one of Claims 1 to 3, **characterized in that** the semiconductor wafer is subjected to an oxidation treatment.

## Revendications

1. Procédé en vue de la fabrication d'un disque semi conducteur en silicium par tronçonnage du disque semi-conducteur d'un monocristal, le monocristal étant tiré d'une masse fondue conformément à la méthode Czochralski en présence d'hydrogène, **caractérisé en ce que** le monocristal est tiré sous une pression partielle d'hydrogène de moins de 3 mbars et dopé à l'aide d'azote et **en ce qu'**il présente une concentration d'azote de 5*10¹² à 5*10¹⁵ atcm⁻³.

2. Procédé selon la revendication 1, **caractérisé en ce que** l'on dispose un écran thermique refroidi autour du monocristal et **en ce que** le monocristal est refroidi à l'aide de l'écran thermique, une période de temps pendant laquelle le monocristal est refroidi d'une température de 1050°C à une température de 900°C, étant de moins de 120 minutes.

3. Procédé selon la revendication 1 ou la revendication 2, **caractérisé en ce que** le disque semi-conducteur est soumis à un traitement thermique dans une atmosphère, qui contient de l'argon et jusqu'à 3% d'hydrogène.

4. Procédé selon l'une quelconque des revendications 1 à 3, **caractérisé en ce que** le disque semi-conducteur est soumis à un traitement d'oxydation.
